# FASCICULE DE BREVET EUROPEEN

(11) **EP 2 154 712 B1**
(45) Date de publication et mention de la délivrance du brevet: **24.07.2013**
(21) Numéro de dépôt: 09167651.0
(22) Date de dépôt: 11.08.2009
(51) Int. Cl.: H01L 21/388, C30B 31/04, C30B 29/16, H01L 29/227

(54) **Procédé de préparation d'un substrat en ZnO en partie ou en totalité semi-isolant ou dopé de type P, substrats obtenus, et dispositifs électroniques, électrooptiques ou optoélectroniques les comprenant.**
Vorbereitungsverfahren eines ZnO-Substrats, das ganz oder teilweise quasi-isolierend oder mit Typ P dotiert ist, so erhaltene Substrate und elektronische, elektrooptische oder optoelektronische Vorrichtungen, die sie enthalten
Method for preparing a partially or fully semi-insulating or P-doped ZnO substrate, substrates obtained, and electronic, electro-optical or optoelectronic devices comprising same.

(30) Priorité: 14.08.2008 FR 0855598
(43) Date de publication de la demande: 17.02.2010
(73) Titulaire: Commissariat à l'Énergie Atomique et aux Énergies Alternatives, 75015 Paris (FR)
(72) Inventeur: Couchaud, Maurice, 38160, Izeron (FR); Chevalier, Céline, 38130, Echirolles (FR)
(74) Mandataire: Augarde, Eric

(56) Documents cités:
- EP-A- 0 338 252
- DATABASE INSPEC [Online] THE INSTITUTION OF ELECTRICAL ENGINEERS, STEVENAGE, GB; 1 avril 2005 (2005-04-01), MEYER B K ET AL: "Shallow donors and acceptors in ZnO" XP002522877 Database accession no. 8420210 & Semiconductor Science and Technology IOP Publishing UK, vol. 20, no. 4, 1 avril 2005 (2005-04-01), pages S62-S66, ISSN: 0268-1242
- WANG ET AL: "Optical properties of p-type ZnO doped by lithium and nitrogen" SOLID STATE COMMUNICATIONS, OXFORD, vol. 141, no. 11, 13 février 2007 (2007-02-13), pages 600-604, XP005886211 ISSN: 0038-1098
- XING G Z ET AL: "Effect of annealing on conductivity behavior of undoped zinc oxide prepared by rf magnetron sputtering" JOURNAL OF ALLOYS AND COMPOUNDS, ELSEVIER SEQUOIA, LAUSANNE, CH, vol. 457, no. 1-2, 12 juin 2008 (2008-06-12), pages 36-41, XP022622632 ISSN: 0925-8388 [extrait le 2008-04-24]

## Description

### DOMAINE TECHNIQUE

L'invention concerne un procédé de préparation d'un substrat en ZnO en partie ou en totalité semi-isolant ou dopé de type p.

L'invention concerne en outre des substrats en ZnO en partie ou en totalité semi-isolants ou dopés de type p.

Ces substrats peuvent notamment trouver leur application dans la fabrication de dispositifs électroniques, électrooptiques ou optoélectroniques et peuvent servir par exemple à la fabrication de diodes électroluminescentes pour l'éclairage, après épitaxie sur ces substrats de matériaux à « grand gap » tels que ZnO ou GaN.

Le domaine technique de l'invention peut donc être défini de manière générale comme celui de la préparation, fabrication de substrats en ZnO au moins en partie semi-conducteurs ou dopés de type p, à partir de substrats commerciaux de ZnO qui sont généralement, naturellement dopés de type n.

### ÉTAT DE LA TECHNIQUE ANTÉRIEURE

Il existe un fort intérêt pour la fabrication de diodes électroluminescentes permettant un éclairage avec une basse consommation énergétique.

L'utilisation d'un matériau à « grand gap » tel que l'oxyde de zinc ZnO ou le nitrure de gallium GaN peut permettre d'obtenir des diodes performantes.

Une des étapes de la fabrication de ces diodes est l'épitaxie de ces matériaux à « grand gap » dopés de type n sur des substrats adaptés dopés de type p.

Aujourd'hui, pour l'épitaxie de GaN les substrats les plus utilisés sont les substrats saphir mais ceux-ci génèrent des contraintes et des dislocations préjudiciables aux rendements des diodes.

Pour l'épitaxie de ZnO les substrats saphir sont également utilisés mais le procédé doit encore être optimisé.

L'épitaxie de ZnO ou de GaN dopés de type n est bien maîtrisée et il serait intéressant de pouvoir la réaliser sur d'autres substrats et notamment sur des substrats en ZnO.

En effet, dans le cas de l'épitaxie du ZnO l'homoépitaxie qui est ainsi réalisée permet de conserver dans la couche de ZnO épitaxiée la qualité cristalline du substrat, lui aussi en ZnO, sans créer des dislocations dues aux contraintes générées par la différence de maille entre la couche épitaxiée et le substrat, caractéristique d'une hétéro-épitaxie.

Dans le cas de l'épitaxie de GaN, l'utilisation d'un substrat en ZnO permet de limiter les contraintes puisque la différence de maille n'est que de 3 %.

Cependant la principale difficulté, le principal obstacle quant à l'épitaxie de matériaux tels que ZnO et GaN dopés de type n sur un substrat de ZnO, en particulier pour la réalisation de diodes, repose sur le fait qu'il est extrêmement difficile de préparer des substrats en ZnO dopés de type p. En d'autres termes, il est très compliqué d'obtenir un dopage p du ZnO du fait que la conductivité naturelle du ZnO est de type n. Actuellement les substrats commerciaux en oxyde de zinc ZnO sont pour la plupart obtenus à partir de cristaux dont la croissance a été réalisée par la méthode de synthèse hydrothermale qui permet d'obtenir les plus grandes dimensions et la meilleure qualité cristalline. Ces cristaux sont naturellement dopés n. Plusieurs documents font mention de procédés pour transformer un substrat en ZnO ayant une conductivité de type n en un substrat semi-isolant ou un substrat à conductivité de type p. Ainsi, le document US-B2-6,936,101 [1] décrit un procédé de préparation d'un monocristal de ZnO semi-isolant par une technique de croissance Bridgman à partir d'une masse fondue de ZnO. Cette technique de croissance est complexe et ne permet d'obtenir des substrats en ZnO semi-isolant que de manière très limitée. Le document de B. K. Meyer et al. [2] : « Shallow Donors and Acceptors in ZnO », Semiconductor Science and Technology, 2005, vol. 20, No. 4, April 2005, S62-S66, fait état d'une modification de la conductivité du ZnO par implantation, diffusion, et dopage d'azote in situ. La diffusion d'azote dans le ZnO est réalisée en utilisant la décomposition thermique du nitrate de lithium et du nitrate d'ammonium à des températures comprises entre 500 et 800°C. Le nitrate de lithium permet d'incorporer de l'azote dans le ZnO suite à sa décomposition thermique au-delà de 600°C. Le document de P. H. Kasai [3] : « Electron Spin Resonance Studies of Donors and Acceptors in ZnO », Physical Review, vol. 130, N°3, 1 May 1963, 989-995, décrit la préparation d'échantillons de ZnO par chauffage d'une poudre fine de ZnO à 900°C pendant 2 heures. Des accepteurs et des donneurs sont introduits en ajoutant à la poudre de ZnO une solution aqueuse d'halogénure ou de nitrate de métal alcalin tel que du nitrate de lithium avant le chauffage. Aussi bien dans le document [2] que dans le document [3] l'intégrité des surfaces des substrats en ZnO n'est pas préservée et est dégradée. Le document de N. Y. GARCES et al. [4] : « Thermal diffusion of Lithium Acceptors into ZnO Crystals » J. of Electronic Materials, Vol. 32, No. 7, 2003, 766-771, a trait à la diffusion thermique d'accepteurs lithium dans des cristaux de ZnO. Un cristal de ZnO placé dans une petite nacelle en céramique est complètement entouré par de la poudre de LiF, et soumis à une série de recuits à une température de 750°C, c'est-à-dire en-dessous de la température de fusion de LiF qui est de 845°C. Dans ce document, la diffusion des éléments ne peut être homogène puisque le contact de la poudre de LiF ne peut être uniforme sur tout le substrat de ZnO. Tous les procédés mentionnés ci-dessus présentent en outre l'inconvénient d'être réalisés à des températures élevées.

### EXPOSÉ DE L'INVENTION

Il existe donc, au vu de ce qui précède un besoin pour un procédé de préparation d'un substrat en ZnO, au moins en partie semi-isolant ou dopé de type p, à partir d'un substrat en ZnO dopé de type n, qui évite toute dégradation de la surface du substrat préparé, tout endommagement de ce substrat, qui permette une modification homogène de la conductivité, et ce quelles que soient la forme et la dimension du substrat.

Il existe en outre un besoin pour un tel procédé qui soit simple, fiable, facile à mettre en oeuvre et qui utilise des températures relativement basses.

Le but de l'invention est de fournir un procédé de préparation d'un substrat en ZnO, au moins en partie semi-isolant ou dopé de type p, à partir d'un substrat en ZnO dopé de type n qui réponde entre autres aux besoins énumérés ci-dessus.

Le but de l'invention est encore de fournir un procédé de préparation d'un substrat en ZnO, au moins en partie semi-isolant ou dopé de type p, à partir d'un substrat en ZnO dopé de type n qui ne présente pas les inconvénients, défauts, limitations, et désavantages des procédés de préparation de l'art antérieur tels que ceux décrits plus haut, et qui résolve les problèmes de ces procédés.

Ce but, et d'autres encore, sont atteints, conformément à l'invention, par un procédé de préparation d'un substrat en ZnO en partie ou en totalité semi-isolant ou dopé de type p, à partir d'un substrat en ZnO dopé de type n, dans lequel on met en contact le substrat en ZnO dopé de type n avec un sel fondu anhydre choisi parmi le nitrate de sodium, le nitrate de lithium, le nitrate de potassium et le nitrate de rubidium fondus anhydres.

La mise en contact peut être généralement réalisée à une température du sel fondu de 264°C à 600°C, de préférence de 350 à 500°C, notamment lorsque le sel est le nitrate de lithium anhydre.

La mise en contact peut être réalisée pendant une durée de 5 minutes à 24 heures, de préférence de 5 heures notamment lorsque le sel est le nitrate de lithium anhydre.

Avantageusement, préalablement à, et de préférence immédiatement avant la mise en contact, le sel fondu est soumis à un traitement thermique de déshydratation.

Avantageusement, ce traitement thermique de déshydratation est réalisé préalablement à la mise en contact et de préférence jusqu'à celle-ci en amenant le sel fondu jusqu'à une température suffisante, et en maintenant cette température suffisante constante pendant une durée suffisante pour que le sel soit rendu anhydre.

Cette température « suffisante » est généralement de 450 à 500°C.

Cette durée « suffisante » est généralement de 24 heures à 48 heures.

La mise en contact peut généralement être réalisée par immersion du substrat en ZnO dopé de type n dans le sel fondu anhydre.

Le procédé selon l'invention peut être défini comme un procédé permettant de modifier facilement la conductivité d'un substrat de ZnO avec une conductivité de type n en un substrat semi-isolant ou en un substrat de conductivité de type p avec une technique très simple de diffusion en milieu liquide.

On peut dire que, selon l'invention, on utilise un liquide anhydre comprenant les éléments qui permettent de compenser la conductivité n et de favoriser l'incorporation d'accepteurs nécessaires à la conductivité de type p.

Par exemple pour un liquide tel que le nitrate de lithium LiNO₃ ces éléments sont le lithium Li s'il est en substitution du zinc, l'azote N s'il est en substitution de l'oxygène ou encore l'oxygène s'il comble les lacunes d'oxygène.

Le procédé selon l'invention n'a jamais été décrit dans l'art antérieur.

Le procédé selon l'invention se distingue fondamentalement des procédés de l'art antérieur notamment du fait de la mise en oeuvre d'un sel fondu, liquide, de plus anhydre pour réaliser cette modification, transformation.

En effet dans le document [2] le nitrate de lithium est décomposé thermiquement dans une ampoule scellée pour donner du Li₂O + NO₂ + H₂O (nitrate hydraté) et seul l'azote de NO₂ gazeux diffuse dans ZnO, tandis que dans le document [3] LiNO₃ est également en solution aqueuse et seules des poudres de ZnO sont traitées.

Contrairement aux procédés décrits dans ces documents [2] et [3], le procédé selon l'invention met en oeuvre un sel sous forme liquide, fondue qui est notamment du nitrate de lithium ou du nitrate de sodium et non une solution aqueuse, le sel reste sous forme liquide, fondue, tout au long du procédé et n'est pas décomposé thermiquement pour générer de l'eau.

Contrairement au procédé décrit dans le document [4] on met en oeuvre selon l'invention un sel fondu liquide choisi parmi quatre sels spécifiques et de préférence parmi deux sels spécifiques LiNO₃ et NaNO₃, et non une poudre de LiF.

Le procédé selon l'invention répond entre autres aux besoins énumérés plus haut, ne présente pas les inconvénients, défauts, limitations et désavantages des procédés de l'art antérieur, et apporte une solution aux problèmes de ces procédés.

Le procédé selon l'invention est très simple, facile à mettre en oeuvre, et ne comporte en fait qu'une seule étape essentielle à savoir celle de mise en contact, par exemple par immersion, du substrat tel qu'un substrat commercial d'oxyde de zinc ayant une conductivité de type n avec le sel fondu, étape au cours de laquelle le substrat est transformé en un substrat à conductivité de type p par diffusion d'éléments contenus dans le liquide.

Le procédé selon l'invention ne nécessite pas d'appareillages complexes, coûteux pour sa mise en oeuvre.

Dans le procédé selon l'invention le sel fondu est anhydre, exempt d'eau, et n'en produit pas lors du procédé, ce qui permet de conserver l'intégrité des surfaces des substrats en ZnO et d'éviter tout endommagement de celles-ci contrairement aux procédés tels que ceux des documents [2] et [3].

Du fait que ZnO est légèrement soluble dans l'eau et que par exemple LiNO₃ est hygroscopique et facilement hydraté il est avantageux de déshydrater le sel, tel que LiNO₃ par chauffage par exemple dans les conditions mentionnées plus haut avant de le mettre en contact avec le substrat en ZnO pour la diffusion.

En outre l'état liquide du sel fondu, tel que le nitrate de lithium, utilisé selon l'invention assure un contact uniforme sur toute la surface du substrat en ZnO, et une diffusion homogène des éléments ce qui n'est pas possible avec une poudre de sel comme dans le document [4].

Cette diffusion homogène des éléments, et ce quelles que soient la taille et la forme du substrat en ZnO, qui est obtenue grâce à la mise en oeuvre selon l'invention d'un sel fondu liquide est l'un des avantages importants du procédé selon l'invention.

Le procédé selon l'invention, du fait des sels spécifiques qui ont été choisis, peut être mis en oeuvre à basse température ce qui entraîne d'importantes économies en matière de consommation d'énergie.

En d'autres termes, dans le procédé selon l'invention, la diffusion peut s'opérer à basse température car, par exemple, la température de fusion de LiNO₃ est de 264°C, la température de fusion de NaNO₃ est de 309°C, la température de fusion du nitrate de rubidium RbNO₃ est de 309°C, et la température de fusion du nitrate de potassium KNO₃ est de 334°C.

Les trois éléments constituants le nitrate de lithium ont un effet favorable au dopage de ZnO de type p par diffusion de lithium, de l'azote et de l'oxygène.

L'oxygène O a un effet oxydant pouvant éventuellement compenser les lacunes en oxygène (qui sont supposées donner la conduction de type n), le lithium Li peut compenser les donneurs en présence en jouant le rôle d'accepteur en substitution du zinc, et l'azote N joue un rôle d'accepteur en substitution de l'oxygène.

En outre le substrat de ZnO n'est pas endommagé par LiNO₃, car ZnO est insoluble dans LiNO₃ fondu et LiNO₃ peut être rapidement, facilement éliminé, par exemple par dissolution dans l'eau ou un alcool par exemple.

Le substrat en ZnO comme on l'a vu plus haut n'est pas non plus endommagé, dégradé par l'eau puisque le sel fondu est anhydre.

Un autre avantage du procédé selon l'invention est que la diffusion peut être contrôlée par la température du liquide et par la durée de la mise en contact, de l'immersion du substrat dans le liquide.

Ce contrôle de la diffusion est extrêmement avantageux car il permet le contrôle de la profondeur de diffusion ; contrairement à d'autres techniques.

Ainsi, il est possible de préparer du ZnO dopé p en couche mince ou sur une épaisseur plus importante, par exemple sur toute l'épaisseur du substrat de ZnO utilisé qui peut être par exemple de 500 µm.

On peut avec le procédé selon l'invention transformer seulement une couche de surface, de préférence d'épaisseur déterminée, du substrat en ZnO dopé de type n en ZnO dopé de type p, ou bien la totalité du substrat en ZnO dopé de type n est transformée en ZnO dopé de type p.

Cette couche peut être une couche mince par exemple d'une épaisseur de 500 nm à 1 micromètre.

Le procédé selon l'invention permet pour la première fois la préparation d'un substrat en ZnO en partie ou en totalité semi-isolant ou dopé de type p, dont le comportement de type p est effectivement prouvé et démontré. On pourra à cet égard se reporter à l'exemple fourni.

Le procédé de l'invention permet la préparation d'un substrat ZnO en partie, ou en totalité semi-isolant ou dopé de type p qui est dopé à la fois par un élément choisi parmi Na, Li, K et Rb ; par N ; et par O.

L'invention a donc également pour objet un substrat en ZnO en partie ou en totalité semi-isolant ou dopé de type p, **caractérisé en ce qu**'il est dopé par diffusion à la fois par un élément choisi parmi Na, Li, K et Rb ; par N ; et par O.

De préférence, ce substrat est dopé à la fois par Li, par N et par O.

Un tel substrat, dopé à la fois, simultanément par un élément choisi parmi Na, Li, K et Rb ; par N ; et par O et plus particulièrement un substrat dopé à la fois, simultanément, par les trois éléments Li, N et O, est intrinséquemment nouveau et n'a jamais été décrit, ni suggéré dans l'art antérieur. Un dopage simultané par un élément choisi parmi Na, Li, K et Rb ; par N ; et par O et plus particulièrement un dopage simultané par les trois éléments Li, N et O est, comme on l'a indiqué plus haut, extrêmement avantageux car chacun de ces trois éléments a un effet favorable au dopage du ZnO de type p.

Ce substrat peut se présenter sous la forme d'une couche mince 2D ou de nanofils.

Ce substrat peut aussi se présenter sous la forme d'un substrat en ZnO de type n, par exemple massif, monolithique, dont une couche de surface, de préférence d'une épaisseur déterminée, a été transformée en ZnO dopé de type p suite au procédé selon l'invention.

Cette couche de surface peut être une couche mince telle que définie plus haut.

Un tel substrat, structure est intrinsèquement nouveau et n'a jamais été décrit ni suggéré dans l'art antérieur.

Une telle structure, compacte, monobloc présente des propriétés optiques et électriques modifiées sur une épaisseur comprise entre 500 nm et 1 µm. De telles propriétés n'avaient pas été obtenues jusqu'alors dans l'art antérieur.

Le procédé selon l'invention permet ainsi de créer des accepteurs présentant des propriétés optiques et électriques différentes sur une épaisseur donnée, déterminée à partir d'un substrat monolithique, massif, en ZnO, naturellement dopé de type n, non (intentionnellement) dopé de type n.

On peut ainsi facilement préparer par un procédé simple, et directement à partir d'un simple substrat monolithique une jonction de type p-n sans faire appel par exemple à de multiples étapes de croissance.

On peut sur le substrat selon l'invention procéder en outre à l'épitaxie de ZnO ou de GaN dopé de type n.

L'invention concerne en outre un dispositif électronique, optoélectronique, ou électrooptique comprenant le substrat selon l'invention.

Ce dispositif est en particulier une diode électroluminescente (DEL) et en particulier une DEL UV.

L'invention sera mieux comprise à la lecture de la description détaillée qui suit, donnée à titre illustratif et non limitatif.

### BRÈVE DESCRIPTION DES DESSINS

La description détaillée est faite en référence aux dessins joints, dans lesquels :

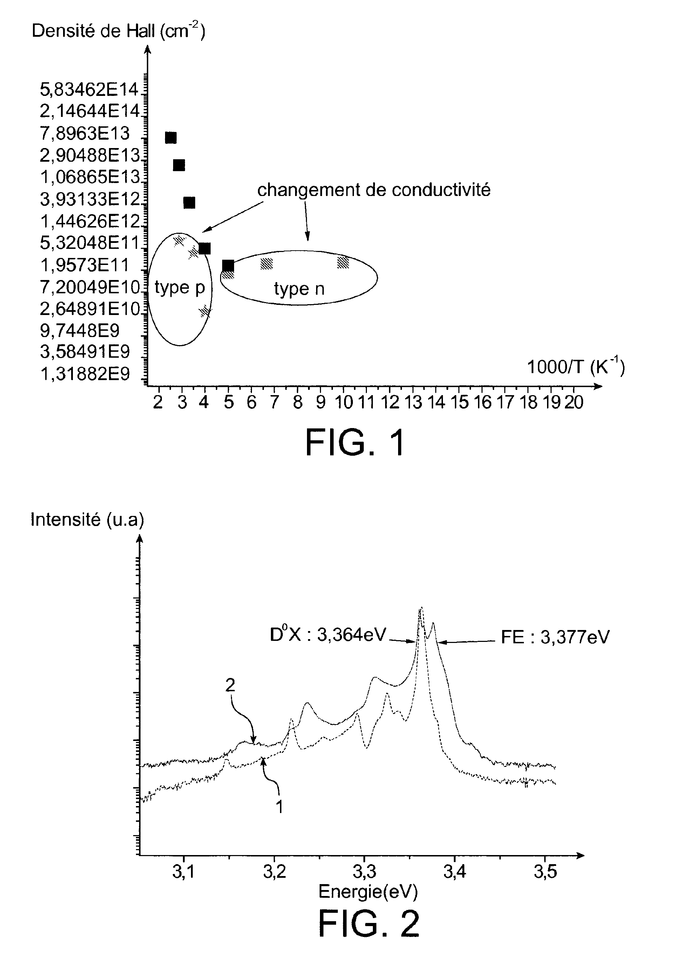

- La Figure 1 est un graphique qui présente la densité de Hall mesurée, (en cm⁻²) en fonction de 1000/T (en K⁻¹) pour un échantillon, substrat en ZnO naturellement de type n, et pour un échantillon, substrat, préparé dans l'exemple 1, conformément au procédé selon l'invention dans du LiNO₃ fondu.

Les carrés noirs représentent la densité de Hall pour le substrat en ZnO naturellement de type n ; les carrés gris clair représentent la densité de Hall pour le substrat préparé dans l'exemple 1, la conductivité mesurée étant de type n ; les étoiles gris clair représentent la densité de Hall pour le substrat préparé dans l'exemple 1, la conductivité mesurée étant de type p.
- La Figure 2 est un graphique qui présente le spectre de photoluminescence (1 en trait pointillé), réalisé sur un échantillon, substrat en ZnO naturellement de type n, et le spectre de photoluminescence (2 en trait continu) réalisé sur l'échantillon, substrat, préparé dans l'exemple 1.

En ordonnée est portée l'intensité (en unités arbitraires u.a), et en abscisse est portée l'énergie (en eV).

### EXPOSÉ DÉTAILLÉ DE MODES DE RÉALISATION

Le procédé selon l'invention est un procédé de préparation d'un substrat en ZnO au moins en partie semi-isolant ou dopé de type p à partir d'un substrat en ZnO dopé de type n dans lequel on met en contact un substrat en ZnO dopé de type n avec un sel fondu anhydre choisi parmi le nitrate de sodium, le nitrate de lithium, le nitrate de potassium, et le nitrate de rubidium.

Le substrat de départ est un substrat en ZnO dopé de type n.

Par substrat dopé de type n, on entend un substrat présentant, naturellement de manière intrinsèque, cette conductivité de type n.

C'est-à-dire que ce ZnO n'a pas été intentionnellement, volontairement dopé de type n, mais présente, cette conductivité de type n de manière intrinsèque, inhérente, par exemple à l'issue de son procédé de préparation par exemple par synthèse hydrothermale, et qu'il est utilisé ainsi, tel qu'il est disponible dans le commerce, sans subir de dopage de type n.

Le substrat de départ est généralement un substrat que l'on peut qualifier de substrat massif, monolithique, par opposition à un substrat pulvérulent.

Le substrat de départ peut avoir une forme et une taille quelconques.

En effet, grâce au procédé selon l'invention on peut traiter avec le mêmes succès des substrats de grande taille et/ou de formes complexes.

Le substrat selon l'invention pourra ainsi avoir la forme d'un carré, de dimensions 10x10 mm² ou d'un disque de diamètre 20 mm : il s'agit là de formes de substrats commercialement disponibles.

Ce substrat peut avoir une épaisseur de cent à quelques centaines de microns, à savoir par exemple 200, 300, 400, 500, 1000 µm.

Généralement, le substrat a une épaisseur d'environ 500 µm.

On peut, avec le procédé selon l'invention préparer un seul substrat ou bien plusieurs substrats simultanément.

Conformément à l'invention, le substrat de départ en ZnO dopé de type n est mis en contact avec un sel fondu, liquide qui est du nitrate de sodium, du nitrate de potassium, du nitrate de rubidium ou du nitrate de lithium fondu.

Le sel préféré est le nitrate de lithium. Le nitrate de lithium fond à une température de 264°C (537,15 K) et reste liquide jusqu'à 600°C (875,15 K), température à laquelle il se décompose. La diffusion des éléments chimiques dans le ZnO peut donc se faire dans le nitrate de lithium dans la plage de 264°C à 600°C, de préférence entre 350°C et 500°C.

Le nitrate de lithium est le sel préféré car l'ion Li, plus petit, diffuse plus facilement dans ZnO et doit être de préférence utilisé.

Les nitrates d'autres éléments alcalins du groupe I tels que : le sodium (Na), le potassium (K) et le rubidium (Rb) peuvent aussi être utilisés mais la diffusion du sodium, du potassium et du rubidium, ions de plus en plus gros, sera plus difficile.

D'autre part le nitrate de sodium NaNO₃, qui fond à 309°C (582,15 K) et reste liquide jusqu'à 538°C (811,15 K) peut se décomposer avec un risque d'explosion, tandis que KNO₃, liquide à 334°C se décompose dès 400°C.

La mise en contact peut se faire par immersion.

Il est préférable que l'ensemble du substrat, à savoir toutes ses surfaces, soit en contact avec le sel fondu.

Selon l'invention le sel fondu est anhydre, ce qui signifie généralement que sa teneur en eau est inférieure à 1% en masse.

Pour être sûr que le sel mis en oeuvre est effectivement anhydre, car LiNO₃ par exemple est hygroscopique et facilement hydraté, il est préférable, préalablement à la mise en contact, de préférence immédiatement avant celle-ci, de procéder à un traitement thermique de déshydratation.

Ainsi, on pourra par exemple, amener préalablement à la mise en contact, le sel fondu à une température suffisante et maintenir cette température suffisante constante pendant une durée suffisante jusqu'à la mise en contact pour que le sel soit anhydre.

Cette température et cette durée suffisante sont par exemple respectivement de 450 à 500°C et de 24 heures à 48 heures.

Lors de la mise en contact par immersion le substrat peut être animé d'un mouvement de translation et/ou de rotation.

Les températures de mise en contact ont déjà été précisées plus haut ainsi que la durée de mise en contact.

Conformément à l'invention la température du liquide et la durée de mise en contact, par exemple d'immersion, permettent de contrôler la diffusion des espèces dans le substrat et la profondeur de diffusion. Il sera ainsi possible grâce à l'invention de ne transformer le substrat de type n que partiellement en substrat de type p ou bien totalement en substrat de type p.

Ainsi on pourra préparer en surface d'un substrat massif, monolithique de ZnO dopé de type n par exemple d'une épaisseur de départ de 500 micromètres une couche, d'une épaisseur donnée, déterminée, désirée, par exemple une couche mince d'une épaisseur de 500 nm à 1 micromètre, de ZnO de type p.

Pour obtenir une couche mince, d'une telle épaisseur de ZnO dopé de type p, la température de mise en contact est généralement de 350 à 500°C et la durée de mise en contact est généralement de 5 minutes à 24 heures.

Si l'on souhaite que la totalité de l'épaisseur de ce même substrat de départ en ZnO de type n soit transformée en ZnO dopé de type p, il faudra utiliser une température de mise en contact généralement de 350 à 500°C et une durée de mise en contact généralement de 1 ou 2 heures à 24 heures.

A l'issue de la mise en contact le substrat est retiré, séparé, du sel liquide fondu. Tout le sel fondu restant peut être éliminé en agitant le substrat, par exemple en lui communiquant un mouvement de rotation.

On peut également éliminer le sel liquide avec de l'eau ou un alcool car LiNO₃ peut être rapidement dissous par exemple dans l'eau ou dans un alcool.

Un substrat de ZnO dopé de type p ou une couche mince de ZnO 2D ou à base de nanofils pourra être préparé selon le procédé de l'invention.

Ainsi préparé, le ZnO dopé de type p dans le volume ou sur une épaisseur contrôlée par la durée du trempage, immersion, mise en contact dans le sel liquide tel que LiNO₃ peut servir de substrat à l'épitaxie de ZnO (ou de GaN) dopé de type n (par exemple par une technique d'épitaxie en phase vapeur telle que la MOCVD). Il est bien évident que si seule une partie du substrat préparée est dopée de type p c'est bien sûr cette partie que l'épitaxie de ZnO ou de GaN dopé de type n est réalisée.

Le dispositif complet ainsi obtenu pourra être utilisé en électronique, électro-optique ou optoélectronique pour la réalisation de diodes pn pour la fabrication de diodes électroluminescentes (DEL ou LED en anglais). Ces diodes électroluminescentes peuvent servir, par exemple, à l'éclairage avec une basse consommation en énergie.

L'invention va maintenant être décrite en référence aux exemples suivants, donnés à titre illustratif et non limitatif.

### EXEMPLE 1 :

200g de nitrate de lithium de haute pureté sont placés dans un creuset en quartz.

L'ensemble est placé dans un four vertical dont la température est pilotée à l'aide d'un ordinateur. La température du creuset est contrôlée par un thermocouple. La température du creuset et celle du bain de sel fondu sont égales.

La température du creuset est amenée à 500°C. Le nitrate de lithium fond à partir de la température de 264°C, puis il reste liquide. La température de 500°C est maintenue constante pendant une durée de 24 heures de manière à s'assurer que le nitrate de lithium soit anhydre.

Un substrat (substrat initial) de ZnO, ayant une conductivité naturelle de type n (substrat de forme carrée 10x10 mm², d'une épaisseur voisine de 500 µm et de masse égale à 0,0655 g de type commercial) est placé sur un porte-substrat animé d'un mouvement de translation de manière à ce que le substrat puisse être immergé dans le liquide pendant la durée choisie, dans cet exemple : 5 heures.

La température du sel fondu est contrôlée à 350°C pendant toute cette durée.

Ensuite, le substrat est retiré du liquide, la rotation du porte-substrat est arrêtée, et le liquide s'écoule.

Le substrat est ensuite déplacé, translaté jusqu'à la sortie du four. Un rinçage rapide à l'eau désionisée pendant 5 secondes permet d'éliminer le reliquat de sel solidifié sur le substrat traité.

On récupère finalement le substrat, échantillon final qui est le résultat de la mise en oeuvre du procédé selon l'invention.
- Caractérisation de l'échantillon, substrat, final obtenu.

Tout d'abord il est à noter que l'on n'observe pas de variation de masse significative ni de modification d'aspect notable.
- Mesures des propriétés électriques par effet Hall sous champ magnétique variable :
   La densité d'électrons mesurée pour le substrat final est plus faible (de 2 ordres de grandeurs) que celle initialement mesurée pour le substrat, initial.
   Une conductivité de type p est mesurée de façon reproductible à 300K pour tous les champs (de 0T à 9T).
   La valeur de la résistivité du substrat final est augmentée de 2 ordres de grandeur (∼10⁴ à 10⁶) par rapport à celle du substrat initial.
   La Figure 1 donne la variation de la densité de Hall mesurée pour l'échantillon préparé conformément au procédé selon l'invention, comme décrit ci-dessus, et celle mesurée pour un substrat de ZnO naturellement de type n, c'est-à-dire n'ayant pas été traité par le procédé selon l'invention. Ce substrat de ZnO naturellement de type n a la même forme carrée et les mêmes dimensions que le substrat traité.
   On note la conductivité de type p (étoiles gris clair) attendue à 300 K et le changement de conductivité de l'échantillon préparé conformément au procédé selon l'invention, comme décrit ci-dessus, d'une conductivité de type n (température de 100 à 400 K) à une conductivité de type p.
   A 300 K, la mobilité obtenue pour l'échantillon mesuré de type p, préparé conformément au procédé selon l'invention, comme décrit ci-dessus, est d'environ 8cm²/Vs.
- Mesures des propriétés optiques par photoluminescence (PL) _{:}
   On réalise les spectres de photoluminescence d'un échantillon, substrat, de ZnO, naturellement, intrinsèquement dopé de type n, et de l'échantillon, substrat final, préparé conformément au procédé selon l'invention, comme décrit ci-dessus.
   Les deux substrats de forme carrée ont les mêmes dimensions (10x10 mm² , épaisseur voisine de 500 µm).

Les conditions de mesure sont les suivantes :
- température de 4 K,
- réseau de 600 traits,
- puissance laser de 50 microwatts,
- 50 micromètres de fente,
- durée d'intégration du spectre de 0,01 seconde pour le substrat naturellement dopé de type n, et de 0,3 seconde pour l'échantillon préparé conformément au procédé selon l'invention dans le nitrate de lithium fondu.
La Figure 2 donne les spectres de photoluminescence PL obtenus dans les conditions précisées plus haut pour l'échantillon préparé dans LiNO₃ fondu, conformément au procédé selon l'invention (courbe 2, en trait plein), et pour un substrat de ZnO, naturellement dopé de type n (courbe 1, en traits pointillés).

Le résultat le plus important concerne le rapport d'intensité du pic nommé D⁰X (exciton lié à un donneur) et du pic nommé FE (exciton libre), qui est plus faible pour l'échantillon préparé, conformément à l'invention, dans LiNO₃ fondu.

Ce résultat est significatif d'une compensation des donneurs en présence, développée dans le document de I.C. ROBIN et al. [5] : Applied Physics Letters, Vol. 92, n° 14 pp 141 101-3 (2008)..

De plus, la photoluminescence PL montre la présence d'une bande de défauts (à plus basse énergie) avec la probable présence de paires donneurs-accepteurs. Ce résultat est aussi caractéristique de la présence d'accepteurs (lithium, azote ou oxygène substitutionnel) vraisemblablement incorporés lors de la trempe du ZnO dans LiNO₃ fondu et pouvant donner la conductivité de type p recherchée.

## Revendications

1. Procédé de préparation d'un substrat en ZnO en partie ou en totalité semi-isolant ou dopé de type p, à partir d'un substrat en ZnO dopé de type n, dans lequel on met en contact le substrat en ZnO dopé de type n avec un sel fondu anhydre choisi parmi le nitrate de sodium, le nitrate de lithium, le nitrate de potassium et le nitrate de rubidium fondus anhydres.

2. Procédé selon la revendication 1 dans lequel la mise en contact est réalisée à une température du sel fondu de 264°C à 600°C, de préférence de 350 à 500°C, notamment lorsque le sel est le nitrate de lithium anhydre.

3. Procédé selon la revendication 1 ou 2 dans lequel la mise en contact est réalisée pendant une durée de 5 minutes à 24 heures, de préférence de 5 heures.

4. Procédé selon l'une quelconque des revendications précédentes, dans lequel, préalablement à, et de préférence immédiatement avant, la mise en contact, le sel fondu est soumis à un traitement thermique de déshydratation.

5. Procédé selon la revendication 4, dans lequel le traitement thermique de déshydratation est réalisé préalablement à la mise en contact et de préférence jusqu'à celle-ci, en amenant le sel fondu jusqu'à une température suffisante, et en maintenant cette température suffisante constante pendant une durée suffisante pour que le sel soit rendu anhydre.

6. Procédé selon la revendication 5, dans lequel la température suffisante est de 450 à 500°C, et la durée suffisante est de 24 à 48 heures.

7. Procédé selon l'une quelconque des revendications précédentes dans lequel la mise en contact est réalisée par immersion du substrat en ZnO dopé de type n dans le sel fondu.

8. Procédé selon l'une quelconque des revendications précédentes dans lequel une couche de surface, de préférence d'une épaisseur déterminée, du substrat en ZnO dopé de type n est transformée en ZnO dopé de type p.

9. Procédé selon la revendication 8 dans lequel la couche de surface est une couche mince d'une épaisseur de 500 nm à 1 micromètre.

10. Procédé selon l'une quelconque des revendications 1 à 7, dans lequel la totalité du substrat en ZnO dopé de type n est transformée en ZnO dopé de type p.

11. Substrat en ZnO en partie ou en totalité semi-isolant ou dopé de type p, **caractérisé en ce qu'**il est dopé par diffusion à la fois par un élément choisi parmi Na, Li, K et Rb ; par N ; et par O.

12. Substrat selon la revendication 11, **caractérisé en ce qu'**il est dopé à la fois par Li, par N et par O.

13. Substrat selon la revendication 11 ou 12 qui se présente sous la forme d'une couche mince 2D ou de nanofils.

14. Substrat selon la revendication 11 ou 12 qui se présente sous la forme d'un substrat, de préférence massif, monolithique, en ZnO de type n dont une couche de surface, de préférence d'une épaisseur déterminée, a été transformée en ZnO dopé de type p.

15. Substrat selon la revendication 14 dans lequel la couche de surface est une couche mince d'une épaisseur de 500 nm à 1 micromètre.

16. Substrat selon l'une quelconque des revendications 11 à 15 sur lequel est en outre épitaxié du ZnO ou du GaN dopé de type n.

17. Dispositif électronique, optoélectronique, ou électrooptique comprenant le substrat selon l'une quelconque des revendications 11 à 16.

18. Dispositif selon la revendication 17 qui est une diode électroluminescente (DEL) en particulier une DEL UV.

## Patentansprüche

1. Verfahren zur Herstellung eines teilweise oder ganz quasi-isolierenden oder mit Typ P dotierten ZnO-Substrats aus einem mit Typ N dotierten ZnO-Substrat, bei dem man das mit Typ N dotierte ZnO-Substrat in Kontakt bringt mit einem wasserfreien geschmolzenen Salz, ausgewählt unter den wasserfreien geschmolzenen Nitraten des Natriums, Lithiums, Kaliums und Rubidiums.

2. Verfahren nach Anspruch 1, bei dem die Kontaktherstellung bei einer Temperatur des geschmolzenen Salzes von 264 °C bis 600 °C und vorzugsweise von 350 bis 500 °C erfolgt, insbesondere dann, wenn das Salz das wasserfreie Lithiumnitrat ist.

3. Verfahren nach Anspruch 1 oder 2, bei dem die Kontaktherstellung während einer Dauer von 5 Minuten bis 24 Stunden, vorzugsweise 5 Stunden, stattfindet.

4. Verfahren nach einem der vorhergehenden Ansprüche, bei dem das geschmolzene Salz vor - und vorzugsweise unmittelbar vor der Kontaktherstellung einer thermischen Trocknungsbehandlung unterzogen wird.

5. Verfahren nach Anspruch 4, bei dem die thermische Trocknungsbehandlung vor der Kontaktherstellung und vorzugsweise bis zu dieser Letzteren durchgeführt wird, indem man das geschmolzene Salz auf eine ausreichende Temperatur bringt und diese ausreichende Temperatur während einer Dauer konstant hält, die ausreicht, um das Salz wasserfrei zu machen.

6. Verfahren nach Anspruch 5, bei dem die ausreichende Temperatur 450 bis 500 °C beträgt, und die ausreichende Dauer 24 bis 48 Stunden beträgt.

7. Verfahren nach einem der vorhergehenden Ansprüche, bei dem die Kontaktherstellung durch Eintauchen des mit Typ N dotierten ZnO-Substrats in geschmolzenes Salz realisiert wird.

8. Verfahren nach einem der vorhergehenden Ansprüche, bei dem eine Oberflächenschicht von vorzugsweise definierter Dicke des mit Typ N dotierten ZnO-Substrats umgewandelt wird in mit Typ P dotiertes ZnO.

9. Verfahren nach Anspruch 8, bei dem die Oberflächenschicht eine Dünnschicht mit einer Dicke von 500 nm bis 1 µm ist.

10. Verfahren nach einem der Ansprüche 1 bis 7, bei dem die Gesamtheit des mit Typ N dotierten ZnO-Substrats umgewandelt wird in mit Typ P dotiertes ZnO.

11. ZnO-Substrat, teilweise oder ganz quasi-isolierend oder mit Typ P dotiert, **dadurch gekennzeichnet, dass** es mittels Diffusion zugleich mit einem unter Na, Li, K und Rb ausgewählten Element; mit N ; und mit O dotiert wird.

12. Substrat nach Anspruch 11, **dadurch gekennzeichnet, dass** es zugleich mit Li, mit N und mit O dotiert wird.

13. Substrat nach Anspruch 11 oder 12, das sich in Form von einer 2D-Dünnschicht oder von Nanofasern präsentiert.

14. Substrat nach Anspruch 11 oder 12, das sich in Form eines vorzugsweise massiven, monolithischen Substrats aus ZnO des Typs N präsentiert, von dem eine Oberflächenschicht mit einer vorzugsweise festgelegten Dicke in mit Typ P dotiertes ZnO umgewandelt worden ist.

15. Substrat nach Anspruch 14, bei dem die Oberflächenschicht eine Dünnschicht mit einer Dicke von 500 nm bis 1 µm ist.

16. Substrat nach einem der Ansprüche 11 bis 15, auf das außerdem ZnO oder GaN, dotiert mit Typ N, epitaxiert wird.

17. Elektronische, optoelektronische oder elektrooptische, das Substrat nach einem der Ansprüche 1 bis 16 umfassende Vorrichtung.

18. Vorrichtung nach Anspruch 17, die eine Elektrolumineszenz-Diode (LED) ist, insbesondere eine UV-LED.

## Claims

1. Method of producing a partly or completely semi-insulating or p-type doped ZnO substrate from an n-type doped ZnO substrate, in which the n-type doped ZnO substrate is brought into contact with an anhydrous molten salt chosen from anhydrous molten sodium nitrate, lithium nitrate, potassium nitrate and rubidium nitrate.

2. Method according to Claim 1, in which the contacting is carried out at a molten salt temperature of 264°C to 600°C, preferably 350 to 500°C, especially when the salt is anhydrous lithium nitrate.

3. Method according to Claim 1 or 2, in which the contacting is carried out for a time of 5 minutes to 24 hours, preferably 5 hours.

4. Method according to any one of the preceding claims, in which the molten salt is subjected to a dehydration heat treatment prior to, and preferably immediately before, the contacting.

5. Method according to Claim 4, in which the dehydration heat treatment is carried out prior to the contacting, and preferably until same, by bringing the molten salt up to a sufficient temperature, and by keeping this sufficient temperature constant for a time sufficient for the salt to be made anhydrous.

6. Method according to Claim 5, in which the sufficient temperature is 450 to 500°C, and the sufficient time is 24 to 48 hours.

7. Method according to any one of the preceding claims, in which the contacting is carried out by immersing the n-type doped ZnO substrate in the molten salt.

8. Method according to any one of the preceding claims, in which a surface layer, preferably of a defined thickness, of the n-type doped ZnO substrate is converted into p-type doped ZnO.

9. Method according to Claim 8, in which the surface layer is a thin layer with a thickness of 500 nm to 1 micron.

10. Method according to any one of Claims 1 to 7, in which the entire n-type doped ZnO substrate is converted into p-type doped ZnO.

11. Partly or completely semi-insulating or p-type doped ZnO substrate, **characterized in that** said substrate is doped by diffusion at the same time by an element chosen from Na, Li, K and Rb ; by N ; and by O.

12. Substrate according to claim 11, **characterized in that** said substrate is doped at the same time by Li, by N, and by O.

13. Substrate according to Claim 11 or 12, which takes the form of a 2D thin layer or the form of nanowires.

14. Substrate according to Claim 11 or 12, which takes the form of a n-type ZnO substrate, preferably a solid monolithic n-type ZnO substrate, a surface layer, preferably of defined thickness, of which has been converted into p-type doped ZnO.

15. Substrate according to Claim 14, in which the surface layer is a thin layer having a thickness of 500 nm to 1 micron.

16. Substrate according to any one of Claims 11 to 15, on which n-type doped GaN or ZnO has furthermore been epitaxially grown.

17. Electronic, optoelectronic or electro-optic device, comprising the substrate according to any one of Claims 11 to 16.

18. Device according to Claim 17, which is a light-emitting diode (LED), in particular a UV LED.
